(19) Europäisches Patentamt

European Patent Office

Office européen des brevets

(11) **EP 1 879 293 B1**

(12) **EUROPEAN PATENT SPECIFICATION**

(45) Date of publication and mention
of the grant of the patent:
**20.02.2019 Bulletin 2019/08**

(51) Int Cl.:
***H03H 17/02*** *(2006.01)* ***H04L 25/03*** *(2006.01)*
***H04S 1/00*** *(2006.01)*

(21) Application number: **07011621.5**

(22) Date of filing: **13.06.2007**

(54) **Partitioned fast convolution in the time and frequency domain**

Partitionierte Schnellfaltung in der Zeit- und Frequenzdomäne

Convolution rapide à partitions dans le domaine temporel et de fréquence

(84) Designated Contracting States:
**DE FR GB**

(30) Priority: **10.07.2006 EP 06014253**

(43) Date of publication of application:
**16.01.2008 Bulletin 2008/03**

(73) Proprietor: **Harman Becker Automotive Systems
GmbH
76307 Karlsbad (DE)**

(72) Inventor: **Christoph, Markus
94315 Straubing (DE)**

(74) Representative: **Grünecker Patent- und
Rechtsanwälte
PartG mbB
Leopoldstraße 4
80802 München (DE)**

(56) References cited:
**WO-A1-01/86808 WO-A1-94/01933**

## Description

### Field of Invention

The present invention relates to digital signal processing and, in particular, the filtering of audio signals by Finite Impulse Response filters (FIR). The invention particularly relates to filtering for echo compensation and equalization by means of long Finite Impulse Response filters.

### Background of the Invention

The enhancement of the quality of signals received in a communication system is a central topic in acoustic and, in particular, speech signal processing. The communication between two parties is often carried out in a noisy background environment and noise reduction as well as echo compensation are necessary to guarantee intelligibility. A prominent example is hands-free voice communication in vehicles.

Of particular importance is the handling of signals of the remote subscriber, which are emitted by the loudspeakers and therefore received again by the microphone(s), since otherwise unpleasant echoes can severely affect the quality and intelligibility of voice conversation. In the worst case acoustic feedback can even lead to a complete breakdown of communication.

To overcome the above mentioned problems means for acoustic echo compensation are provided, which basically works as follows. A replica of the acoustic feedback is synthesized and a compensation signal is obtained from the received signal of the loudspeakers. This compensation signal is subtracted from the sending signal of the microphone thereby generating a resulting signal to be sent to the remote subscriber.

Furthermore, equalization of audio signals is usually necessary in order to enhance the quality of transmitted signals to an acceptable level, e.g., to increase the intelligibility of received speech signals that are sent by a remote communication party in hands-free telephony. The equalization filtering means usually processes the acoustic input signal by boosting or attenuating the signals over a pre-determined frequency range. The equalization filtering means may comprise a shelving filter for selectively boosting/attenuating either the low or high frequency range and a peaking filter for boosting/attenuating signals with the center frequency, bandwidth in-band and out-band gains being separately adjustable. The equalization filtering means may further comprise a parametric equalizer that combines one or more shelving filters and peaking filters.

One main problem with currently available filtering means is the huge amount of filter coefficients to be adapted or to be optimized for an enhancement of the quality of the processed audio signal which results in very high memory requirements and a heavy processor load of the signal processing means. In the case of echo compensation filtering means, the sampling rate is therefore often limited to about 8 kHz which is considered marginally tolerable for speech signals.

For equalization filtering means Infinite Response (IIR) filters are usually employed, since implementation of Finite Impulse Response (FIR) filters has not been proven successful for the above mentioned reason. Equalizing has mainly to be performed in the high and mid frequency ranges and have to be realized with a relatively high accuracy for unreduced sampling rates of, e.g., about 44 kHz for acceptable results. Thus, very long filters comprising many filter coefficients become necessary. FIR filters, however, would be advantageous, since, e.g., they are unconditional stable filters (the filter output is not fed back) and easy to design.

To solve the above-mentioned problem it has been proposed to use short filters designed in a distorted frequency range, so-called warped FIR or IIR filters. However, warped filters also suffer from the need for a long computation time. According to an alternative approach, multirate digital systems or filter banks for dividing the audio signal that is to be processed in multiple frequency ranges by parallel band pass filters have been used for equalizing. However, this approach suffers from high memory requirements and a high latency, i.e. a long travel time of a signal from the input to the output of a filtering means.

WO 01/86808 A1 discloses a digital filter comprising means for determining a partial filter input initial condition, using a partitioned filter input signal, and partitioned filter input coefficients, means for determining a partial filter output initial condition, using a partitioned filter output signal and partitioned filter output coefficients, and means for realizing said digital filter as a sum of outputs of FIR filter elements, wherein inputs of said FIR filter elements are dependent upon said partial filter input initial condition and said partial filter output initial condition, and said current block of filter input signal values.

WO 94/01933 A1 discloses an apparatus including a digital filter with a long impulse response and lower latency, built by operating a numbr of small component filters in parallel and combining their outputs by addition, with each component filter operating with a different delay such that the net operation of the ensemble of said component filters is the same as a single filter with a longer impulse response, and the latency of the ensemble is equal to the shortest latency of the component filters.

Despite the recent developments and improvements, there is still a need for an improved filtering of digital signals by FIR filtering means. It is therefore the problem underlying the present invention to overcome the above-mentioned drawbacks and to provide a method for filtering digital signals and a long FIR filtering means with reduced requirements for computer resources and a reduced latency. Moreover, the FIR filtering means must be readily adoptable to a given kind of a digital signal processor.

**Description of the invention**

The above mentioned problems are solved by the herein disclosed method for processing a digital input signal by a Finite Impulse Response, FIR, filtering means, according to claim 1. The claimed method for processing a digital input signal by an FIR filtering means comprises the steps of partitioning a first portion of the digital input signal in the time domain to obtain T partitions of the digital input signal, where T is an integer bigger than 1; partitioning the FIR filtering means in the time domain to obtain T+S partitions of the FIR filtering means, where S is an integer bigger than 1; Fourier transforming the T partitions of the digital input signal to obtain Fourier transformed signal partitions;
Fourier transforming a second portion of the digital input signal that is different from the first portion of the digital input signal;
partitioning the Fourier transformed second portion of the digital input signal to obtain S Fourier transformed signal partitions;
Fourier transforming the T+S partitions of the FIR filtering means to obtain Fourier transformed filter partitions;
performing a convolution of both the T and S Fourier transformed signal partitions and the corresponding Fourier transformed filter partitions to obtain spectral partitions;
combining the spectral partitions to obtain a total spectrum; and
inverse Fourier transforming the total spectrum to obtain a digital output signal in the time domain.

The digital input signal can, e.g., be an audio signal or a speech signal. The inventive method is particularly useful in the context of speech signal processing. Based on the Fourier transformations the convolution is performed in the frequency domain (which translates to the so-called circular convolution in the time domain).

It should be noted that whereas the disclosed method necessarily includes the Fourier transformation steps, the Fourier transforms are not necessarily calculated online in course of the filtering process. Rather, the FIR filter partitions can be Fourier transformed beforehand and can be stored in an external memory. This is particularly useful in the case of limited computer resources and a sufficiently large external memory. Storage of transformed filter partitions is also advantageous, if the FIR filtering means is not changed with time.
Partial or complete calculation of the Fourier transforms of filter partitions and storage of the Fourier transformed filter partitions beforehand may be carried according to the hardware resources that are available in a particular application.

It should be stressed that partitioning of the FIR filtering means is entirely carried out in the time domain. The partitions are convoluted in the spectral (frequency) domain. This mixed time - frequency processing allows for an implementation in an actual application under consideration of the advantages and disadvantages of the time and frequency processing, respectively.

It is well known that in contrast to a circular or fast convolution processing in the time regime, as in the case of a usual convolution process, is notoriously computationally expensive. On the other hand, signal processing in the frequency domain suffers from enormous memory requirements.
For given hardware resources the inventive method allows for an optimized usage of the available computer resources for the filtering of digital signals by long FIR filtering means by an appropriate choice of the chosen partition lengths. Filter lengths can be employed that would not be practicable in terms of the processor load and/or memory requirements by filtering methods of the art.
In addition, the latency of the signal processing according to the inventive method as well as the internal memory requirements and the processor load can be controlled by the length of the Fast Fourier transformation (FFT). The latency is given by twice the length of the employed FFT. The internal memory requirements increase proportional to the FFT length and is approximately four times the FFT length. The processor load increases with decreasing FFT lengths.
According to the inventive method the digital input signal is partly partitioned in the time domain to obtain partitions of the input signal that are subsequently Fourier transformed and partly partitioned in the spectral domain. According to inventive method a combined partitioned fast convolution of a digital input signal in the time and the spectral domain can be performed that allows for selecting the number of partitions in each of the time and the spectral domain to be selected in accordance with the available computer resources. On the one hand, the number of the partitions in the time domain can be chosen such that the computing time is acceptable for an efficient signal processing (without causing audible artifacts). On the other hand, the number of partitions in the spectral domain (complex values) can be chosen such that the demand for memory does not exceed the available memory resources and/or the capacity of an interface employed for data transfer. The allocation (distribution) of partitions in the time and in the spectral domain may be controlled automatically or by a user.

Moreover, the total spectrum obtained by a fast convolution can, in particular, be obtained by only using half of the number of the Fourier components of the Fourier transformed filter partitions. Efficient processing is, thus, enabled. In a particularly efficient implementation of the herein disclosed method the Fourier transformed signal partitions and the Fourier transformed filter partitions are all of the same bandwidth and the mid frequencies are distributed on an equidistant discrete frequency raster. More complicated algorithms for the calculation of the distribution of the mid frequencies are possible and might be applied depending on the actual application.

It should be noted that alternatively to the above described embodiments of the inventive method a realization of the FIR filtering by means of decimation filter banks, in particular, critical decimation filter banks, in the time domain is possible.

The present invention also provides a computer program product, comprising one or more computer readable media having computer-executable instructions for performing the steps of an above-described example of the inventive method.

The above-mentioned problems are also solved by a signal processing means for processing a digital input signal, in particular, an audio signal or a speech signal, according to claim 5 comprising

a partitioning means configured to partition a first portion of the digital input signal in the time domain to obtain T partitions of the digital input signal, where T is an integer;

an FIR filtering means partitioned in the time domain thereby comprising T+S partitions, where S is an integer;

Fourier transforming means configured to a) Fourier transform the T partitions of the digital input signal separately to obtain Fourier transformed signal partitions b) Fourier transform a second portion of the digital input signal that is different from the first portion of the digital input signal and c) Fourier transform the T+S partitions of the FIR filtering means to obtain Fourier transformed filter partitions;

wherein the partitioning means is further configured to partition the Fourier transformed second portion of the digital input signal to obtain S Fourier transformed signal partitions; and

wherein the FIR filtering means is configured to filter the digital input signal by performing a convolution of the Fourier transformed signal partitions and the corresponding Fourier transformed filter partitions to obtain spectral partitions; and further comprising

an adder configured to sum up the spectral partitions to obtain a total spectrum; and an inverse Fourier transforming means configured to inverse Fourier transform the total spectrum to obtain a digital output signal in the time domain. The FIR filtering means performs filtering of the digital input signal by convolving the Fourier transformed signal partitions and the corresponding Fourier transformed filter partitions of the same frequency range.

According to an example, the signal processing means may further comprise a block dividing means configured to divide the digital input signal into blocks of equal or different sizes and the FIR filtering means may advantageously be configured to perform an overlap-save block convolution.

According to an example of the signal processing means the Fourier transforming means is configured to separately Fast Fourier transform each partition of a digital input signal that is partitioned in the time domain to obtain Fourier transformed signal partitions. Since according to this embodiment each partition is can be retrieved separately from an external storage means, expensive internal memory can be saved. Since a plurality of FFTs is necessary in this case, computing time raises and also a fast interface to the external memory is necessary.

The above described examples of the signal processing means can be advantageously used in equalization filtering means as well as echo compensation filtering means, if made adaptable. The equalization filtering means can, in particular, be applied to realize a static convolution with a long fixed FIR filter whith adjustable latency time.

The invention, moreover, provides a hands-free set and a speech recognition system and a speech dialog system each comprising one of the above mentioned examples of the signal processing means according to the present invention. A speech recognition system is a means for recognizing verbal utterances by analyzing the corresponding digitized speech signals. A speech dialog system includes a speech recognition system for processing a speech input and also includes a synthetic speech output means.

Additional features and advantages of the present invention will be described with reference to the drawings. In the description, reference is made to the accompanying figures that are meant to illustrate preferred embodiments of the invention. It is understood that such embodiments do not represent the full scope of the invention.

Figure 1 illustrates basic components of an example of the herein disclosed method for processing a digital input signal including partitioning of an FIR filtering means in time.

Figure 2 illustrates the processing of a digital input signal by an example of the partitioned fast convolution of a digital input signal.

Figure 3 illustrates the processing of a digital input signal by another example of the partitioned fast convolution of a digital input signal.

Figure 4 illustrates the processing of a digital input signal by a combined partitioned fast convolution in the time and in the spectral domain according to the invention.

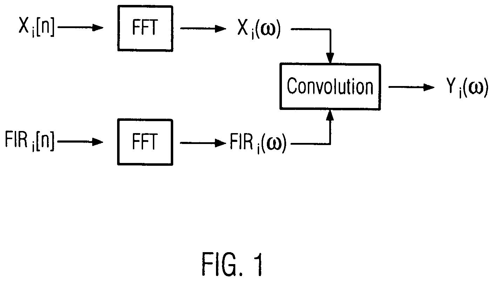

According to the present invention echo compensating or equalizing of audio signals can be performed by an FIR filtering means even when a huge number of filter coefficients must be employed in order to obtain an acoustic or speech signal of satisfying quality. The herein disclosed method comprises convolution of a digital input signal in the frequency domain. As shown in Figure 1 partitions of the input signal $x_i[n]$ indexed by integers i are subject to a Fast Fourier transformation FFT to obtain the Fourier transformed signal partitions $X_i(\omega)$ for predetermined frequency ranges. It is a main aspect of the present invention that an FIR filter is entirely partitioned in the time domain to obtain filter partitions $FIR_i[n]$. According to the present example an equal number of filter partitions $FIR_i[n]$ and signal partitions $X_i(\omega)$ is chosen. Convolution by means of a long FIR filtering means can be carried out by a number of elementary fast convolutions with the respective filter partitions.
Independent of the number of the FIR filter coefficients the latency is determined by the length of the chosen FFT. In fact, the latency is given by twice the FFT length. In order to carry out the fast convolutions, the filter partitions $FIR_i[n]$ are Fast Fourier transformed to obtain Fourier transformed filter partitions $FIR_i(\omega)$:

$$FIR_i = \sum_{n=0}^{N_F-1} x[n] \exp\left(-\frac{2\pi i}{N_F} n\omega\right),$$

An FFT is an algorithm to compute the above sum in $O(N_F \log N_F)$ operations In practice, the FFT can be carried out, e.g., by means of the Cooley-Tukey algorithm.
The Fourier transformed signal partitions $X_i(\omega)$ are convoluted with the corresponding Fourier transformed filter partitions $FIR_i(\omega)$ to obtain results of the individual convolution processes $Y_i(\omega)$ as shown in Figure 1. The desired output signal $y[n]$ obtained as the result of the signal processing is subsequently achieved by summing up the signals $Y_i(\omega)$ and subsequently inverse Fast Fourier transforming the resulting total signal. The latency of the signal processing can be controlled by the length of the FFT, i.e. $N_F$. In symbolic notation the desired output signal is obtained by

$$y[n] = \text{IFFT}(Y(\omega)) \quad \text{with} \quad Y(\omega) = \sum Y_i(\omega) = \sum X_i(\omega) \cdot FIR_i(\omega),$$

where IFFT denotes the inverse Fast Fourier transformation.

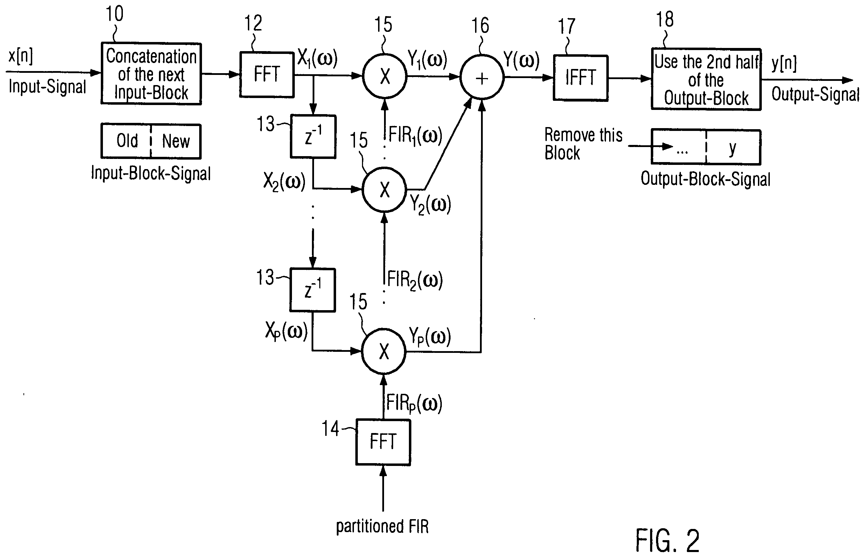

Figure 2 illustrates an example of the partitioned fast convolution method. The fast convolution is carried out for signal blocks by means of the overlap-save method. Details on the overlap-save FFT can be found, e.g., in Theory and applications of digital signal processing, Rabiner, L. and Gold, B., Englewood Cliffs, NJ, Prentice-Hall, 1975.
An input audio signal x[n] is divided into blocks. Incoming blocks are sequentially concatenated 10 for processing. An incoming block is Fast Fourier transformed 12 to obtain Fourier transformed signal partitions $X_i(\omega)$. The individual Fourier transformed signal partitions $X_i(\omega)$, i = 1, .., p, represent the spectral representations of the respective signal partitions in the time domain and can thus be obtained by delay filtering 13 in the frequency regime.
The partitions of an FIR filtering means partitioned in the time domain are Fast Fourier transformed 14 to obtain Fourier transformed filter partitions $FIR_i(\omega)$, i = 1, .., p. Each Fourier transformed signal partitions $X_i(\omega)$ is convoluted by the corresponding Fourier transformed filter partition $FIR_i(\omega)$ 15 and the results $Y_i(\omega)$ are summed up 16 to obtain a total spectrum $Y(\omega)$. According to the present example, the total spectrum $Y(\omega)$ is the result of a fast convolution of the input signal block with half of the FFT length with the entire FIR filtering means that is partitioned in the time domain.
The output signal y[n] is obtained by means of an inverse Fast Fourier Transformation (IFFT) 17 of $Y(\omega)$ and by keeping the second half of the output block 18 achieved by the IFFT.

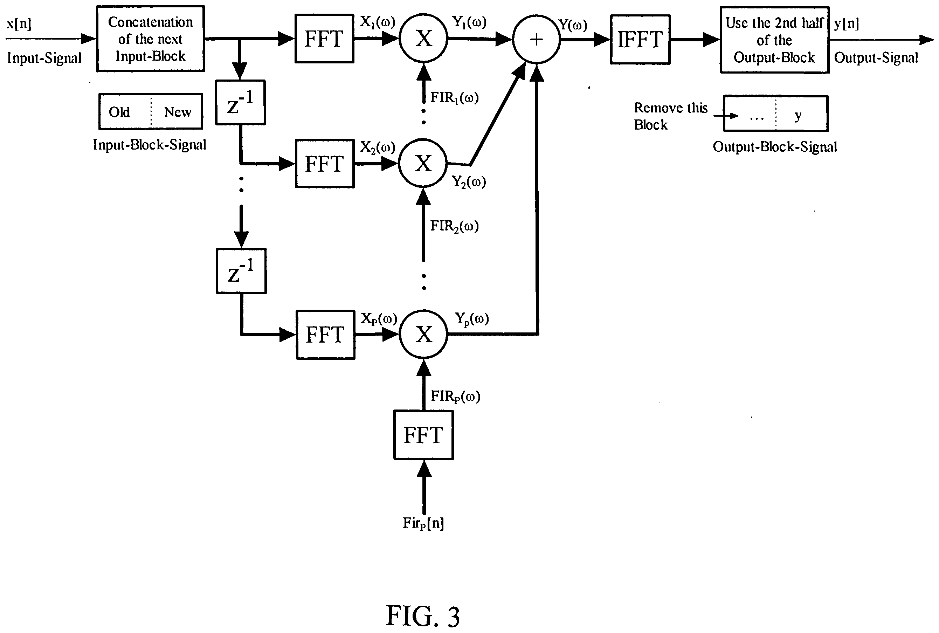

Figure 3 shows an alternative embodiment of the above described example of the partitioned fast convolution method. In this example, the partitioning of the digital input signal x[n] is not performed by the FFT filtering means itself but rather by a preceding partitioning delay line. Consequently, an FFT is performed for each of the partitions of the digital input signal x[n]. Further processing is performed as described above with reference to Figure 2.
Contrary to the example employing one single FFT of the digital input signal (see Figure 2) a plurality of FFTs is necessary. Consequently, the computing time raises and also a fast interface to the external memory is necessary. On the other hand, the costs for the internal memory can be reduced, since each partition is separately retrieved from an external memory and is subsequently loaded in the internal memory. Depending on the available hardware resources one might choose from the above mentioned two alternatives. This illustrates the flexibility of the partitioned fast convolution method according to the alternative embodiment of the above described example.

It is noted that the signal partitions may be Fourier transformed beforehand and the Fourier transformed signal partitions may be stored which is advantageous, if in a particular signal processing situation a relatively small number of input signals is to be convoluted with a relatively large number of FIR filters.

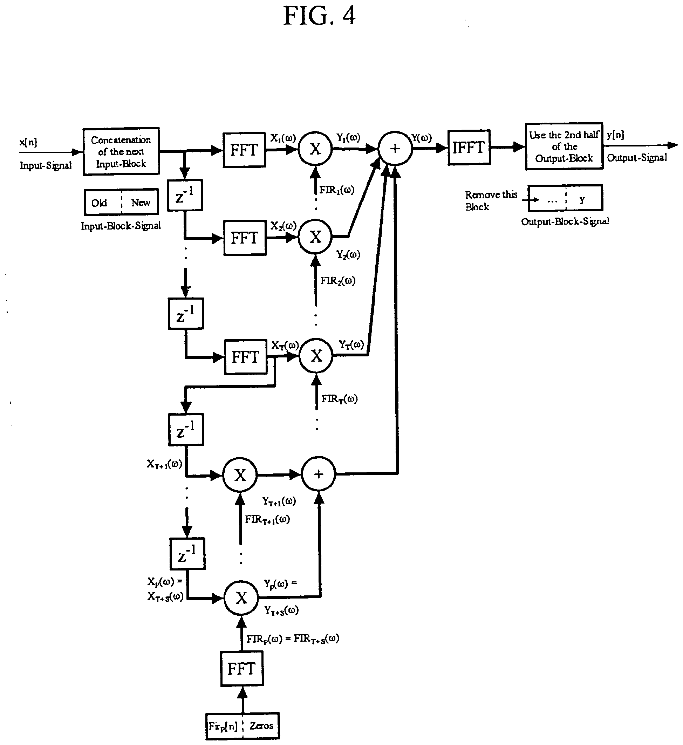

In Figure 4 a combined partitioning of the digital input signal x[n] in the time and in the spectral domain according to the invention is illustrated. Different from the example shown in Figure 3, only part of the digital input signal x[n] is partitioned in the time domain by means of time delay filtering. On the one hand, T partitions $x_1[n]$, .., $x_T[n]$ of the input signal x[n] are each Fast Fourier transformed to obtain T Fourier transformed signal partitions $X_1(\omega)$, .. $X_T(\omega)$. On the other hand, S already Fourier transformed parts of the input signal are partitioned in the spectral domain to obtain S partitions in the spectral domain $X_{T+1}(\omega)$, .. $X_{T+S}(\omega)$. The Fourier transformed signal partitions $X_1(\omega)$, .., $X_{T+S}(\omega)$ are then convoluted by the corresponding Fourier transformed filter partition $FIR_1(\omega)$, ..., $FIR_{T+S}(\omega)$, and the results $Y_1(\omega)$, .., $Y_{T+S}(\omega)$ are summed up to obtain the total spectrum $Y(\omega)$.

**Claims**

1. Method for processing a digital input signal (x[n]) by a Finite Impulse Response, FIR, filtering means, comprising partitioning a first portion of the digital input signal (x[n]) in the time domain to obtain T partitions ($x_T[n]$) of the digital input signal, where T is an integer bigger than 1; partitioning the FIR filtering means in the time domain to obtain T+S partitions ($FIR_T[n]$, $FIR_S[n]$) of the FIR filtering means, where S is an integer bigger than 1; Fourier transforming the T partitions ($x_T[n]$) of the digital input signal (x[n]) to obtain
Fourier transformed signal partitions ($X_T(\omega)$);
Fourier transforming a second portion of the digital input signal (x[n]) that is different from the first portion of the digital input signal (x[n]);
partitioning the Fourier transformed second portion of the digital input signal (x[n]) to obtain S Fourier transformed signal partitions ($X_S(\omega)$);
Fourier transforming (14) the T+S partitions ($FIR_T[n]$, $FIR_S[n]$) of the FIR filtering means to obtain Fourier transformed filter partitions ($FIR_T(\omega)$, $FIR_S(\omega)$);
performing a convolution (15) of both the T and S Fourier transformed signal partitions ($X_T(\omega)$, $X_S(\omega)$) and the corresponding Fourier transformed filter partitions ($FIR_T(\omega)$, $FIR_S(\omega)$) to obtain spectral partitions ($Y_1(\omega)$, .., $Y_{T+S}(\omega)$);
combining (16) the spectral partitions ($Y_1(\omega)$, .., $Y_{T+S}(\omega)$) to obtain a total spectrum ($Y(\omega)$); and
inverse Fourier transforming (17) the total spectrum ($Y(\omega)$) to obtain a digital output signal y([n]) in the time domain.

2. The method according to claim 1 wherein the Fourier transformed signal partitions ($X_T(w)$, $X_S(w)$) and the Fourier transformed filter partitions ($FIR_T(w)$, $FIR_S(W)$) are all of the same bandwidth and the mid frequencies are distributed on an equidistant discrete frequency raster.

3. Computer program product, comprising one or more computer readable m having computer-executable instructions for performing the steps of the method according to one of the claims 1 and 2.

4. Signal processing means for processing a digital input signal, in particular, an a signal or a speech signal, comprising a partitioning means configured to partition a first portion of the digital input signal (x[n]) in the time domain to obtain T partitions ($X_T[n]$) of the digital input signal, where T is an integer bigger than 1; an FIR filtering means partitioned in the time domain thereby comprising T+S partitions ($FIR_T[n]$, $FIR_S[n]$), where S is an integer bigger than 1; Fourier transforming means (12) configured to a) Fourier transform the T partitions ($x_T[n]$) of the digital input signal (x[n]) separately to obtain Fourier transformed signal partitions ($X_T(\omega)$) b) Fourier transform a second portion of the digital input signal (x[n]) that is different from the first portion of the digital input signal (x[n]) and c) Fourier transform the T+S partitions ($FIR_T[n]$, $FIR_S[n]$) of the FIR filtering means to obtain Fourier transformed filter partitions ($FIR_T(\omega)$, $FIR_S(\omega)$);
wherein the partitioning means is further configured to partition the Fourier transformed second portion of the digital input signal (x[n]) to obtain S Fourier transformed signal partitions ($X_S(\omega)$); and
wherein the FIR filtering means is configured to filter the digital input signal (x[n]) by performing a convolution (15) of the Fourier transformed signal partitions ($X_T(\omega)$, $X_S(\omega)$) and the corresponding Fourier transformed filter partitions ($FIR_T(\omega)$, $FIR_S(\omega)$) to obtain spectral partitions ($Y_1(\omega)$, .., $Y_{T+S}(\omega)$);
and further comprising
an adder (16) configured to sum up the spectral partitions ($Y_1(\omega)$, .., $Y_{T+S}(\omega)$) to obtain a total spectrum ($Y(\omega)$); and
an inverse Fourier transforming means (17) configured to inverse Fourier transform the total spectrum ($Y(\omega)$) to obtain a digital output signal (y[n]) in the time domain.

**5.** Hands-free set comprising a signal processing means according to claim 4.

**6.** processing means according to one of the claims 4 and 5.

**Patentansprüche**

**1.** Verfahren zur Verarbeitung eines digitalen Eingangssignals (x[n]) durch ein Filtermittel mit endlicher Impulsantwort, FIR, umfassend

Partitionieren eines ersten Abschnitts des digitalen Eingangssignals (x[n]) in der Zeitdomäne, um T Partitionen ($x_T$[n]) des digitalen Eingangssignals zu erhalten, wobei T eine ganze Zahl ist, die größer als 1 ist;

Partitionieren des FIR-Filtermittels in der Zeitdomäne, um T+S Partitionen ($FIR_T$[n], $FIR_S$[n]) des FIR-Filtermittels zu erhalten, wobei S eine ganze Zahl ist, die größer als 1 ist; Fourier-Transformieren der T Partitionen ($x_T$[n]) des digitalen Eingangssignals (x[n]), um Fourier-transformierte Signalpartitionen ($X_T(\omega)$) zu erhalten;

Fourier-Transformieren eines zweiten Abschnitts des digitalen Eingangssignals (x[n]), der sich von dem ersten Abschnitt des digitalen Eingangssignals (x[n]) unterscheidet;

Partitionieren des Fourier-transformierten zweiten Abschnitts des digitalen Eingangssignals (x[n]), um S Fourier-transformierte Signalpartitionen ($X_S(\omega)$) zu erhalten;

Fourier-Transformieren (14) der T+S Partitionen ($FIR_T$[n], $FIR_S$[n]) des FIR-Filtermittels, um Fourier-transformierte Filterpartitionen ($FIR_T(\omega)$, $FIR_S(\omega)$) zu erhalten;

Durchführen einer Faltung (15) sowohl der T als auch der S Fourier-transformierten Signalpartitionen ($X_T(\omega)$, ($X_S(\omega)$) und der entsprechenden Fourier-transformierten Filterpartitionen ($FIR_T(\omega)$, $FIR_S(\omega)$), um Spektralpartitionen ($Y_1(\omega)$, .., $Y_{T+S}(\omega)$) zu erhalten;

Kombinieren (16) der Spektralpartitionen ($Y_1(\omega)$, .., $Y_{T+S}(\omega)$), um ein Gesamtspektrum ($Y(\omega)$) zu erhalten; und

inverses Fourier-Transformieren (17) des Gesamtspektrums ($Y(\omega)$), um ein digitales Ausgabesignal y([n]) in der Zeitdomäne zu erhalten.

**2.** Verfahren nach Anspruch 1, wobei die Fourier-transformierten Signalpartitionen ($X_T$(w), $X_S$(w)) und die Fourier-transformierten Filterpartitionen ($FIR_T(\omega)$, (w), $FIR_S$(w)) alle die gleiche Bandbreite aufweisen und die Mittelfrequenzen auf einem äquidistanten diskreten Frequenzraster verteilt sind.

**3.** Computerprogrammprodukt, umfassend ein oder mehrere computerlesbare Medien, die computerausführbare Anweisungen aufweisen, um die Schritte des Verfahrens nach einem der Ansprüche 1 und 2 durchzuführen.

**4.** Signalverarbeitungsmittel zur Verarbeitung insbesondere eines digitalen Eingangssignals und eines Audiosignals oder eines Sprachsignals, umfassend

ein Partitionierungsmittel, das konfiguriert ist, um einen ersten Abschnitt des digitalen Eingangssignals (x[n]) in der Zeitdomäne zu partitionieren, um T Partitionen ($x_T$[n]) des digitalen Eingangssignals zu erhalten, wobei T eine ganze Zahl ist, die größer als 1 ist;

ein FIR-Filtermittel, das in der Zeitdomäne partitioniert ist, wodurch es T+S Partitionen ($FIR_T$[n], $FIR_S$[n]) umfasst, wobei S eine ganze Zahl ist, die größer als 1 ist;

Mittel zur Fourier-Transformation (12), die konfiguriert sind, um a) an den T Partitionen ($x_T$[n]) des digitalen Eingangssignals (x[n]) separat Fourier-Transformationen durchzuführen, um Fourier-transformierte Signalpartitionen ($X_T(\omega)$) zu erhalten, b) an einem zweiten Abschnitt des digitalen Eingangssignals (x[n]), der sich von dem ersten Abschnitt des digitalen Eingangssignals (x[n]) unterscheidet, Fourier-Transformationen durchzuführen, und c) an den T+S Partitionen ($FIR_T$[n], $FIR_S$[n]) des FIR-Filtermittels Fourier-Transformationen durchzuführen, um Fourier-transformierte Filterpartitionen ($FIR_T(\omega)$, $FIR_S(\omega)$) zu erhalten;

wobei das Partitionierungsmittel ferner konfiguriert ist, um den Fourier-transformierten zweiten Abschnitt des digitalen Eingangssignals (x[n]) zu partitionieren, um S Fourier-transformierte Signalpartitionen ($X_S(\omega)$) zu erhalten;

und wobei das FIR-Filtermittel konfiguriert ist, um das digitale Eingangssignal (x[n]) zu filtern, indem eine Faltung (15) der Fourier-transformierten Signalpartitionen ($X_T(\omega)$, ($X_S(\omega)$) und der entsprechenden Fourier-transformierten Filterpartitionen ($FIR_T(\omega)$, $FIR_S(\omega)$) durchgeführt wird, um Spektralpartitionen ($Y_1$ ($\omega$), .., $Y_{T+S}(\omega)$) zu erhalten; und ferner umfassend

einen Addierer (16), der konfiguriert ist, um die Spektralpartitionen ($Y_1(\omega)$, .., $Y_{T+S}(\omega)$) zu summieren, um ein Gesamtspektrum ($Y(\omega)$) zu erhalten; und

ein Mittel zur inversen Fourier-Transformation (17), das konfiguriert ist, um an dem Gesamtspektrum ($Y(\omega)$) inverse Fourier-Transformationen durchzuführen, um ein digitales Ausgabesignal (y[n]) in der Zeitdomäne zu erhalten.

**5.** Freisprecheinrichtung, umfassend ein Signalverarbeitungsmittel nach Anspruch 4.

**6.** Verarbeitungsmittel nach einem der Ansprüche 4 und 5.


**Revendications**

**1.** Procédé de traitement d'un signal d'entrée numérique (x[n]) par un moyen de filtrage de réponse impulsionnelle finie, FIR, comprenant

le partitionnement d'une première partie du signal d'entrée numérique (x[n]) dans le domaine temporel pour obtenir T partitions ($x_T$[n]) du signal d'entrée numérique, où T est un entier supérieur à 1 ;

le partitionnement du moyen de filtrage FIR dans le domaine temporel pour obtenir T+S partitions ($FIR_T$[n], $FIR_S$[n]) du moyen de filtrage FIR, où S est un entier supérieur à 1 ;

la réalisation d'une transformée de Fourier concernant les T partitions ($x_T$[n]) du signal d'entrée numérique (x[n]) pour obtenir des partitions de signal ayant subi une transformée de Fourier ($x_T(\omega)$) ;

la réalisation d'une transformée de Fourier concernant une seconde partie du signal d'entrée numérique (x[n]) qui est différente de la première partie du signal d'entrée numérique (x[n]) ;

le partitionnement de la seconde partie du signal d'entrée numérique (X[n]) ayant subi une transformée de Fourier pour obtenir S partitions de signal ayant subi une transformée de Fourier ($X_S(\omega)$) ;

la réalisation d'une transformée de Fourier (14) concernant les T+S partitions ($FIR_T$[n], $FIR_S$[n]) du moyen de filtrage FIR pour obtenir des partitions de filtre ayant subi une transformée de Fourier ($FIR_T(\omega)$, $FIR_S(\omega)$) ;

la réalisation d'une convolution (15) à la fois des T et S partitions de signal ayant subi une transformée de Fourier ($X_T(\omega)$, ($X_S(\omega)$) et des partitions de filtre ayant subi une transformée de Fourier ($FIR_T(\omega)$, $FIR_S(\omega)$) correspondantes pour obtenir des partitions spectrales ($Y_1(\omega)$, ..., $Y_{T+S}(\omega)$) ;

la combinaison (16) des partitions spectrales ($Y_1(\omega)$, ..., $Y_{T+S}(\omega)$) pour obtenir un spectre total ($Y(\omega)$) ; et

la réalisation d'une transformée de Fourier inverse (17) concernant le spectre total ($Y(\omega)$) pour obtenir un signal de sortie numérique y([n]) dans le domaine temporel.

**2.** Procédé selon la revendication 1, dans lequel les partitions de signal ayant subi une transformée de Fourier ($X_T$(w), ($X_S$(w)) et les partitions de filtre ayant subi une transformée de Fourier ($FIR_T(\omega)$, $FIR_S$(w)) sont toutes de la même bande passante et les fréquences intermédiaires sont distribuées sur une trame de fréquence discrète équidistante.

**3.** Produit de programme informatique, comprenant un ou plusieurs [tronqué] lisibles par ordinateur ayant des instructions exécutables par ordinateur pour exécuter les étapes du procédé selon l'une des revendications 1 et 2.

**4.** Moyen de traitement de signal pour traiter un signal d'entrée numérique, en particulier, un signal [tronqué] ou un signal vocal, comprenant

un moyen de partitionnement configuré pour partitionner une première partie du signal d'entrée numérique (x[n]) dans le domaine temporel pour obtenir T partitions ($x_T$[n]) du signal d'entrée numérique, où T est un entier supérieur à 1 ;

un moyen de filtrage FIR partitionné dans le domaine temporel comprenant ainsi T+S partitions ($FIR_T$[n], $FIR_S$[n]), où S est un entier supérieur à 1 ;

un moyen de réaliser une transformée de Fourier (12) configuré pour a) réaliser une transformée de Fourier concernant les T partitions ($x_T$[n]) du signal d'entrée numérique (x[n]) séparément pour obtenir des partitions de signal ayant subi une transformée de Fourier ($X_T(\omega)$) b) réaliser une transformée de Fourier concernant une seconde partie du signal d'entrée numérique (x[n]) qui est différente de la première partie du signal d'entrée numérique (x[n]) et c) réaliser une transformée de Fourier concernant les T+S partitions ($FIR_T$[n], $FIR_S$[n]) du moyen de filtrage FIR pour obtenir des partitions de filtre ayant subi une transformée de Fourier ($FIR_T(\omega)$, $FIR_S(\omega)$) ;

dans lequel le moyen de partitionnement est en outre configuré pour partitionner la seconde partie du signal d'entrée numérique (x[n]) ayant subi une transformée de Fourier pour obtenir S partitions de signal ayant subi une transformée de Fourier ($X_S(\omega)$) ; et

dans lequel le moyen de filtrage FIR est configuré pour filtrer le signal d'entrée numérique (x[n]) en réalisant une convolution (15) des partitions de signal ayant subi une transformée de Fourier ($X_T(\omega)$, ($X_S(\omega)$) et des partitions de filtre ayant subi une transformée de Fourier ($FIR_T(\omega)$, $FIR_S(\omega)$) correspondantes pour obtenir des partitions spectrales ($Y_1(\omega)$, ..., $Y_{T+S}(\omega)$) ;

et comprenant outre

un additionneur (16) configuré pour additionner les partitions spectrales ($Y_1(\omega)$, ..., $Y_{T+S}(\omega)$) afin d'obtenir un spectre total ($Y(\omega)$) ; et

un moyen de réaliser une transformée de Fourier inverse (17) configuré pour réaliser une transformée de Fourier inverse concernant le spectre total $(Y(\omega))$ afin d'obtenir un signal de sortie numérique $(y[n])$ dans le domaine temporel.

5.  Kit mains libres comprenant un moyen de traitement de signal selon la revendication 4.

6.  Moyen de traitement selon l'une des revendications 4 et 5.

FIG. 1

FIG. 2

# FIG. 3

# FIG. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0186808 A1

- WO 9401933 A1

**Non-patent literature cited in the description**

- **RABINER, L. ; GOLD, B.** Theory and applications of digital signal processing. Prentice-Hall, 1975